(19)

Europäisches
Patentamt
European
Patent Office
Office européen
des brevets

(11) **EP 4 108 628 A1**

(12) **EUROPEAN PATENT APPLICATION**

(43) Date of publication:
**28.12.2022 Bulletin 2022/52**

(21) Application number: **21180945.4**

(22) Date of filing: **22.06.2021**

(51) International Patent Classification (IPC):
***B81C 1/00*** *(2006.01)*

(52) Cooperative Patent Classification (CPC):
**B81C 1/00373;** B81B 2201/051; B81B 2203/0127;
B81B 2203/0315; B81B 2203/0338

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **NEDERLANDSE ORGANISATIE VOOR
TOEGEPAST-
NATUURWETENSCHAPPELIJK ONDERZOEK
TNO
2595 DA 's-Gravenhage (NL)**

(72) Inventors:
• **HENDRIKS, Rob Jacob
2595 DA 's-Gravenhage (NL)**
• **MAALDERINK, Herman Hendrikus
2595 DA 's-Gravenhage (NL)**
• **BRUNING, Fabien Bernard Jacques
2595 DA 's-Gravenhage (NL)**

(74) Representative: **V.O.
P.O. Box 87930
2508 DH Den Haag (NL)**

(54) **METHOD OF MANUFACTURING A LAYERED 3D PRODUCT**

(57)    A method of manufacturing a layered 3D product comprises providing (S2) a radiation transparent film (5) that carries a resin layer (6) which in at least a first lateral region (51) of a first sublayer (61) at a side of the film is at least substantially cured and which is at least substantially uncured in a second sublayer (62) thereof that has a free surface (622) at a side of the resin layer facing away from the radiation transparent film. The film is laminated (S3) with a target, wherein the resin layer faces the target. The resin layer is fully cured (S4) in at least a third lateral region (53). Subsequently, the film is delaminated (S5) from the target. Therewith the fully cured material of the resin layer present in the at least a third lateral region remains on the target and the film and the remainder of resin material thereon are removed from the target.

FIG. 3

EP 4 108 628 A1

## Description

BACKGROUND

EP1719607 discloses a method for forming a three-dimensional object layer-by-layer wherein a solidifiable liquid build material is transferred from a first side of a radiation transparent build material carrier to a receiving substrate. Subsequently, an image from a radiation source is projected through the radiation transparent build material carrier to selectively illuminate pixels in an image plane in a first exposure to selectively solidify the liquid build material.

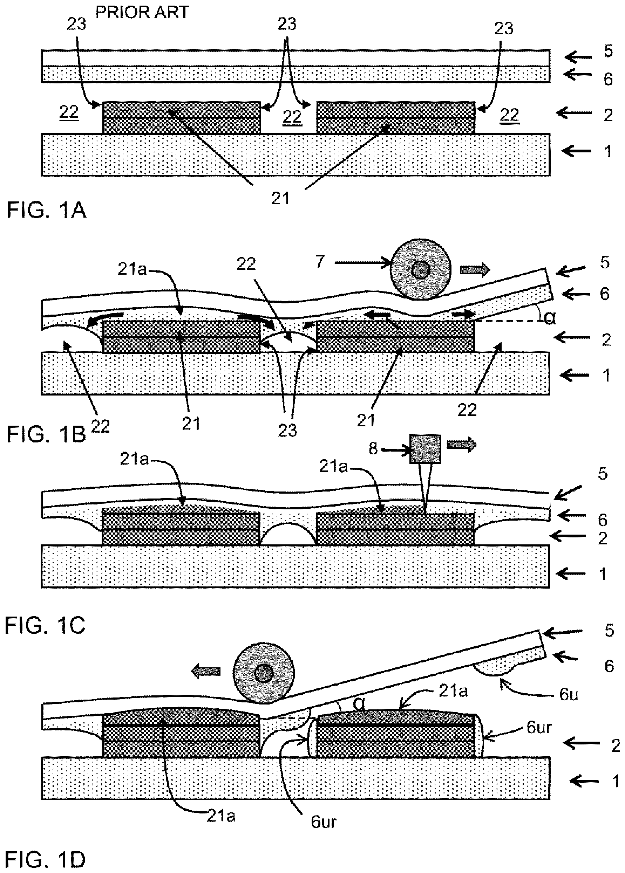

This known process is schematically illustrated in FIG. 1A-1D. In a first step shown in FIG. 1A, the radiation transparent build material carrier, e.g. a transparent film 5, provided with a layer 6 of the solidifiable liquid build material, e.g. a curable resin is positioned above the receiving substrate 1. As shown in the example of FIG. 1A, the receiving substrate is provided with a patterned layer 2 having sublayers deposited in preceding process steps that form elevated sections 21 and recessed sections 22 between said elevated sections.

In a second step shown in FIG. 1B, the film 5 carrying the curable resin layer 6 is laminated with the substrate 1 using a lamination roller 7. As indicated by arrows in the layer 6, the pressure exerted during lamination causes the curable resin, which is still in a liquid state, to flow towards the recessed sections of the patterned layer. Therewith a sublayer 21a of curable resin remains on the elevated sections 21 that has a non-uniform height profile, in that the height of the sublayer 21a decreases towards the boundaries 23.

In a third step shown in FIG. 1C, the sublayers 21a at the elevated sections 21 having the non-uniform height profile is cured using a photon radiation source 8.

In a fourth step as shown in FIG. 1D, the film 5 is delaminated from the substrate 1. Therewith a portion 6u of the uncured resin material is removed from the substrate. It is a disadvantage however, that other portions 6ur of uncured resin material remain at boundaries of the elevated sections of the patterned layer 2. Moreover, as noted above, it is a disadvantage that the sublayers 21a at the elevated sections 21 obtained with the method have a non-uniform height profile.

SUMMARY

It is an object of the present invention to provide an improved method of manufacturing a layered 3D product that at least mitigates the above-mentioned disadvantages.

According to this object, the improved method comprises adding a layer with the following subsequent steps.

A target is provided. The target is for example a building platform, substrate on which the layered 3D product is to be built or a semi-finished version of the 3D product, e.g. comprising one or more already present product layers. A substrate may be provided for example of a glass, a metal or a polymer.

A radiation transparent film is provided that carries a resin layer which in at least a first lateral region of a first sublayer is at least substantially cured, and which resin layer is at least substantially uncured in a second sublayer thereof that has a free surface at a side of the resin layer facing away from the radiation transparent film.

The film is laminated with the target, wherein the resin layer faces the target.

Subsequent to lamination the resin layer is fully cured in at least a third lateral region.

Then, the film is delaminated from the substrate. Therewith the film and resin material thereon outside the at least a third lateral region is removed from the target, and the fully cured material of the resin layer present in the at least a third lateral region is left on the target.

As the first sublayer is at least substantially cured in at least a first lateral region before the lamination takes place, a relatively thick resin layer can be applied while a flow of the liquid resin during lamination is restricted. As a result, the pressure of the laminating drum/bar and wetting behavior of the resin will have limited to no impact on the layer thickness. In case the target surface has recessed portions, a flow of liquid resin therein during lamination is also mitigated.

Typically the first curing step solidifies the liquid resin to a depth of around 80 - 95% of the total layer thickness, depending on the total layer thickness. The uncured layer after the first curing step is ideally in the range of 0.5 - 5 $\mu$m. It is also possible to partially cure the second sublayer layer during the first curing step, to increase the viscosity this thin layer. The higher the viscosity of this thin layer, the lower the chance of material flowing into underlaying air cavities.

At least the resin in the second sublayer should be a photocurable resin. The resin used for the first sublayer, which is still at least substantially uncured in second lateral regions outside the first lateral regions may be of another type, e.g. thermo-curable, but is preferably also a photocurable resin. As will become apparent from examples below the first sublayer and the second sublayer may be provided starting from a same photocurable resin. Photocurable resins can be selected from commercially available compositions. Typically a photocurable resin comprises a mixture of monomers, oligomers and one or more photo-initiators. In the presence of light the mixture undergoes a process called curing, where oligomers are cross-linked upon exposure to light, forming a network polymer.

The radiation transparent film is for example of a polymer like PET, PEN or PI and may have thickness in the range of e.g. about 50 micron to about 1 mm.

To easily delaminate the transparent polymer film from the cured part, the surface tension of the resin should be in the same order of magnitude or be lower than the surface energy of the film. If the surface tension of the resin is much higher than the surface energy of the film, it is difficult to remain a smooth homogenous layer. For example, PET has a surface energy of around 42 dyne/cm, which means that the surface tension of the resin should be in the same range, but preferably lower (30 - 35 dyne/cm).

Next to the surface tension of the liquid and surface energy of the film, the roughness of the film also affects the delamination force. Rough surfaces will increases the surface area and increase the mechanical adhesion. Hence it is desired to use films with a roughness (Ra) in the range of 1 - 100 nm.

In an embodiment, the first sublayer comprises at least a substantially uncured second lateral region between a first lateral region that is to be removed with the film during delaminating, and another first lateral region that is to remain at the target subsequent to said delaminating. Therewith shear forces during lamination are avoided. In an example thereof the second lateral region has a width exceeding twice a positioning tolerance in the step of laminating the film with the substrate. Should it be the case that a lateral shift of the film has occurred during lamination, then the boundaries of the third lateral regions can be adapted while being sure that uncured resin material remains between the third lateral region and a neighboring first lateral region that is to be removed with the film during delamination. Therewith shear forces are minimized. This mitigates the risk that the film or a newly deposited resin layer is torn apart during delamination. This also renders possible deposition of an overhanging new cured resin layer and/or depositing a new cured resin layer defining an opening.

The improved method is particularly suitable for manufacturing a layered 3D product enclosing a cavity. In this example the improved method comprises a step of applying the layer on a target formed by a substrate that carries at least a first patterned layer having elevated sections and recessed sections. Due to the fact that the resin layer has a first sublayer that is at least substantially cured over its surface even a recessed section can be covered with a mechanically strong resin layer, while avoiding that an excessive amount of uncured resin flows in the recessed section during the lamination step. Accordingly, an exemplary product obtained with the method is characterized by a cavity enclosed within a recessed section of a patterned layer and a cover of a cured resin layer having a layer thickness, wherein cured resin material of the cured resin layer is absent in the recessed section at a distance from the elevated section exceeding 0.2 times the layer thickness. As an example, a recessed area having a cross-section of 400 $\mu$m would require that a thickness of the cover is minimally 50 $\mu$m to avoid sagging. Despite the substantial thickness, the improved embodiment of the method renders it possible to reduce a flow of the resin used for the cover to at most a few micron into the recessed section.

In an embodiment of the improved method, the step of providing a transparent film carrying a resin layer comprises a first sub-step and a second sub-step, which are specified as follows. In the first sub-step the film is provided with an uncured resin layer. In the second sub-step photon radiation is directed via the film to the first lateral regions in the uncured resin layer.

In an example, the sub-step of directing photon radiation is performed in the presence of oxygen. Oxygen diffuses from the side of the free surface into the resin layer, and therewith inhibits curing in a thin layer of resin at a free surface of the resin layer, so that the resin layer in its entirety is uncured near its free surface. Depending on the environmental oxygen level and light intensity (curing speed) the oxygen inhibition layer thickness can be controlled. The faster the curing, the lower the oxygen diffusion into the layer. So ideally the light intensity is tuned to standard ambient conditions, to reduce the complexity of the system. A more complex system would include an oxygen controlled environment to control the oxygen inhibition layer thickness. Subsequent to lamination, sections of the resin layer in third lateral regions that coincide with one or more of the elevated sections of the patterned layer are still curable by applying photon-radiation with an increased intensity as compared to that applied during the second sub-step referred to above.

In an embodiment, a wavelength and an intensity of the photon-radiation are selected in relation to a thickness and transmission characteristics of the resin layer to achieve that the cured lateral sections are formed in the first lateral regions of the first resin sublayer and that resin material in the second resin sublayer remains uncured. Photon radiation having an optical energy density which is at least equal to the critical optical energy density of the resin therewith initiates a polymerization of the resin through the photodegradation of an initiator to form radicals, cations, or carbene-like species. Due to absorption in the resin layer, the intensity of the photon-radiation decreases exponentially in a direction from the side of the film to the free surface of the resin layer. Therewith beyond a certain depth t curing of the resin layer is avoided.

The cure depth t is computed as follows:

$$t = \log (E0/Ec) / c\varepsilon$$

Therein:

E0 is the optical energy density at the surface of the resin facing the film,
Ec is the critical optical energy density, and
ce is the absorption coefficient.

Therewith, given a desired cure dept t and values for the critical optical energy density Ec and the absorption coefficient ce of the resin used, the required optical energy density E0 can be computed with:

$$E0 = Ec * e^{t*ec}$$

Even if the properties of the resin are not exactly known, the required optical energy density E0 can be determined with a few routine measurements as the achieved cure depth is a monotonous increasing function of the optical energy density E0. If desired, an absorbent for the photon radiation may be provided as an additive in the resin layer to provide for a stronger decay of the optical energy density as a function of the depth in the resin layer. Therewith the cure depth can be controlled with a higher accuracy.

In still another embodiment the cure depth is controlled by a combination of measures comprising a setting of the optical energy density E0 to a predetermined value as a first measure to restrict the curing depth and by performing the sub-step of directing photon radiation in the presence of oxygen as a second measure.

In a still further embodiment, the first sub-step of providing the film with an uncured resin layer comprising providing the uncured resin layer as first sub-layer and a second sub-layer with mutually different curing requirements.

In one example, the mutually different curing requirements of the first sub-layer and the second sub-layer comprise a mutually different photon-radiation wavelength required to initiate curing. In this example, in the second sub-step of the step of providing a transparent film carrying a resin layer photon radiation of a first wavelength is used to cure the first sub-layer in the first lateral regions. After the lamination, photon-radiation of a second wavelength is used to cure the second sub-layer in the third lateral regions that coincide with the one or more of the elevated sections of the patterned layer.

In another example, the mutually different curing requirements of the first sub-layer and the second sub-layer comprise a mutually different critical optical energy density of the photon-radiation, wherein the critical optical energy density of the second sub-layer is higher than that of the first sub-layer. In this example, in the second sub-step of the step of providing a transparent film carrying a resin layer photon radiation of a first optical energy density suitable to cure the first sub-layer over its full depth is used. After the lamination, photon-radiation of a higher optical energy density is used that is suitable to cure the second sub-layer over its full depth in the third lateral regions that coincide with the one or more of the elevated sections of the patterned layer.

In again another example the first sub-layer and the second sub-layer have a mutually different photon-radiation wavelength required to initiate curing and in addition the second sub-layer has a critical optical energy density that is higher than that of the first sub-layer.

Optionally an intermediate step is performed wherein uncured photocurable resin is partially removed from the film before laminating the film with the target. Uncured resin may be partially removed by flushing. Another option is to partially remove uncured resin by scraping with a flexible doctor blade. This contributes to mitigating an uncontrolled flow of uncured material during the lamination step.

In an embodiment the first sublayer has a thickness that is larger than that of the second sublayer. In exemplary embodiments, the thickness of the first sublayer is 5 to 10 times larger than that of the second sublayer. Therewith a total thickness of uncured resin material is substantially reduced. Therewith also an undesired flow of uncured resin material is substantially mitigated. The relatively thin second sub-layer nevertheless suffices to adhere the resin layer in the third lateral regions that coincide with the one or more of the elevated sections of the patterned layer by the step of fully curing subsequent to lamination.

In preferred embodiments, a magnitude of a surface tension of the uncured resin is lower than a magnitude of a surface energy of the film on which it is provided. A relatively low magnitude of a surface tension of the uncured resin as compared to a magnitude of a surface energy of the film contributes to a good homogeneity of the resin layer. It is further preferred that already cured layers present on the substrate have a high surface energy. This facilitates an increase in lamination speed, and allows air can to be pushed away more easily during lamination.

In an embodiment at least one lateral section of the resin layer is provided with a round going wall which is cured while at least one region in an area enclosed by the round going wall is left uncured. In examples thereof, the area enclosed by the round going wall comprises at least one cured subregion enclosed by uncured resin. Cured subregion enclosed by uncured resin form pillars that can be used to control the layer thickness but that leave room for the uncured resin to flow. This is in particular advantageous for embodiments wherein oxygen inhibition is used to inhibit curing of the resin layer near its free surface. Photo-initiators in the uncured resin enclosed by the round going wall can diffuse in the direction of the free surface of the resin layer to facilitate further curing subsequent to lamination.

In an embodiment of the method one or more of the uncured second lateral regions of the resin layer are provided as channels that substantially extend in a direction corresponding to a direction of laminating. Such channels contribute to a controlled flow of uncured resin during lamination. For example, when air cavities are desired in the 3D product, the uncured resin should not flow into the empty cavities. By introducing channels, the liquid resin can flow around the air cavity more easily. In most preferred embodiments, the flow resistance for uncured resin within the channels is low as compared to a flow resistance for uncured resin in the second sublayer of the resin layer present between the elevated sections of the patterned layer and the uncured resin in the second sublayer of the resin layer and the at least substantially cured resin in the first lateral regions of the resin layer.

In an embodiment, the first patterned layer has laterally distributed pillar shaped elements within a recessed section and wherein a lateral section of the resin film that is to face the recessed section is precured in its entirety.

This embodiment is particularly suitable to provide the 3D-product with air cavities. Large area air cavities are beneficial for example for the performance of RF antenna's. The presence of the laterally distributed pillar shaped elements provide support for a membrane that is formed by the lateral section of the resin film. Therewith it is rendered possible to form a relatively large overhang with a relatively thin membrane, while mitigating the risk that the membrane breaks during delamination, or collapses in a later stage.

Embodiments of the improved method are particularly suitable for use as part of a chip packaging method. An embodiment of a chip packaging method using the improved method comprises the following subsequent steps.

A package bottom layer is provided that carries a chip having at least one electronic component and having electric terminals at a first side facing away from the bottom layer. The package bottom layer further carries a patterned layer having an elevated section and a recessed section, the chip is accommodated in the recessed section and is circumferentially enclosed by the elevated section.

A first connector membrane layer is provided that extends over the first side of the chip and the elevated section of the patterned layer and that defines openings giving access to respective ones of the electric terminals of the chip.

Conductor lines of an electrically conductive material are deposited on the first connector membrane layer. The conductor lines electrically connect respective ones of the electric terminals with respective package terminals.

A second connector membrane layer is deposited on the first connector membrane layer with the conductor lines. Therewith the conductor lines are enclosed between the first connector membrane layer and the second connector membrane layer.

One or more of the first connector membrane layer and the second connector membrane layer is provided with an embodiment of the improved method of manufacturing.

In this connection it is noted that photocurable polymers generally tend to be subject to residual stress after curing which could involve the risk that products packaged therein are damaged. Even worse, photocurable polymers generally have a relatively high CTE in comparison to silicon chips, which would even increase the risk of damage in case of an increase of temperature.

In view of this observation, in a first example of the embodiment of the chip packaging method the step of providing the package bottom layer with the chip comprises the following subsequent sub-steps.

A first patterned sublayer of the patterned layer having an elevated section and a recessed section is provided on the substrate.

A first flexible membrane is provided on the elevated section of the first patterned layer.

A second patterned sublayer having an elevated section and a recessed section is formed on the first flexible membrane. The elevated section of the second patterned sublayer is supported by the elevated section of the first patterned sublayer via the first flexible membrane.

The chip is adhered to a surface of the first flexible membrane that faces away from the substrate.

The flexible membrane arranged over the recessed section provides for a stress-free suspension of the chip within the package.

Also the connector membranes may be flexible to further mitigate mechanical stress exerted to the chip. By sandwiching a chip in between two flexible membranes, the chip is free to move within the air cavity of the 3D printed part.

In a second example of the chip packaging method that optionally comprises one, more or all steps of the first example of the embodiment of the chip packaging method, further comprises the following steps.

A further patterned layer having an elevated section that is supported by the elevated section of the second patterned sublayer via the connector membrane layers is provided.

A cover layer is deposited on the elevated section of the further patterned layer.

The cover layer may be provided with a through hole to allow gasses and liquids to make contact with the chip. This could be useful for packaging sensor chips and applications where liquid cooling is desired.

The present disclosure further provides an improved manufacturing apparatus and an improved manufacturing arrangement.

BRIEF DESCRIPTION OF THE DRAWINGS

These and other aspects are described in more detail with reference to the drawing. Therein:

FIG. 1A-1D illustrate subsequent steps of a prior art manufacturing method;
FIG. 2 - 5 schematically depict steps of an embodiment of the improved manufacturing method; Therein FIG. 2 illustrates a first and a second step, FIG. 3 shows a third step, FIG. 4 shows a fourth step and FIG. 5 shows a fifth step;
FIG. 6A shows a step of an embodiment in more detail;
FIG. 6B schematically shows a logarithmic relationship an energy density of applied optical radiation and a thickness up to which resin material is cured;
FIG. 7A-7D illustrates how the thickness to be cured can be controlled according to various approaches;

FIG. 8A-8C depict sub-steps of a step according to an other embodiment of the improved method;

FIG. 9A and 9B show an example of an intermediate product obtained in a step of the improved method; Therein FIG. 9B is a cross-section according to IXB-IXB in FIG. 9A;

FIG. 10A, 10B and 10C show another example of an intermediate product obtained in said step S2; Therein FIG. 10B is a cross-section according to XB-XB in FIG. 10A and FIG. 10C is a cross-section according to XC-XC in FIG. 10A.

FIG. 11A, 11B and FIG. 12A and 12B illustrate how features of the intermediate product of FIG. 9A, 9B facilitates exemplary subsequent manufacturing steps; Therein FIG. 11A and FIG. 11B shows the exemplary subsequent manufacturing steps without the features of the intermediate product of FIG. 9A, 9B and FIG. 12A and 12B illustrate the exemplary subsequent manufacturing steps in the presence of the features of the intermediate product;

FIG. 13A, 13B and 13C show subsequent steps in an embodiment of the improved method;

FIG. 14A and 14B show a chip package; Therein FIG. 14B is a top-view according to XIVB in FIG. 14A, wherein some hidden elements are indicated by dashed lines;

FIG. 15A-15D show exemplary applications;

FIG. 16 shows a further application;

FIG. 17 shows a first embodiment of a manufacturing apparatus performing a manufacturing step;

FIG. 18 shows the first embodiment of the manufacturing apparatus performing a subsequent manufacturing step;

FIG. 19 shows a second embodiment of the manufacturing apparatus performing the subsequent manufacturing step;

FIG. 20 shows the first embodiment of the manufacturing apparatus performing a further subsequent manufacturing step;

FIG. 21 shows the first embodiment of the manufacturing apparatus performing a still further subsequent manufacturing step;

FIG. 22 shows the first embodiment of the manufacturing apparatus performing an again further subsequent manufacturing step;

FIG. 23 shows the first embodiment of the manufacturing apparatus performing an intermediate step;

FIG. 24 shows the first embodiment of the manufacturing apparatus having completed again the first mentioned manufacturing step;

FIG. 25 shows a first embodiment of a manufacturing arrangement comprising the first embodiment of the manufacturing apparatus;

FIG. 26 shows an exemplary processing schedule for the manufacturing arrangement of FIG. 25;

FIG. 27 shows a second embodiment of a manufacturing apparatus performing a manufacturing step;

FIG. 28 shows a second embodiment of a manufacturing arrangement comprising the second embodiment of the manufacturing apparatus;

FIG. 29 shows an exemplary processing schedule for the manufacturing arrangement of FIG. 28.

## DETAILED DESCRIPTION OF EMBODIMENTS

Like reference symbols in the various drawings indicate like elements unless otherwise indicated.

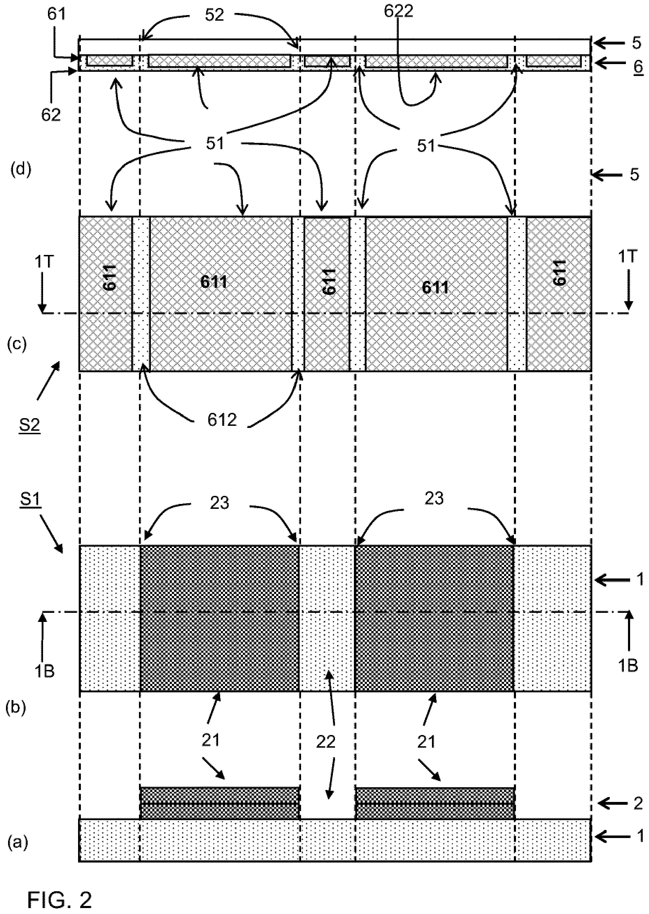

FIG. 2 - 5 schematically depicts an improved method of manufacturing a layered 3D product. The improved method comprises adding a layer with the following steps.

As shown in parts c and d of FIG. 2 a radiation transparent film 5 is provided in step S2. The film 5 carries a resin layer 6 that in a first sublayer 61 is at least substantially cured in at least a first lateral region 51, that is at least substantially uncured in a second sublayer 62 that has a free surface 622 at a side of the resin layer facing away from the radiation transparent film.

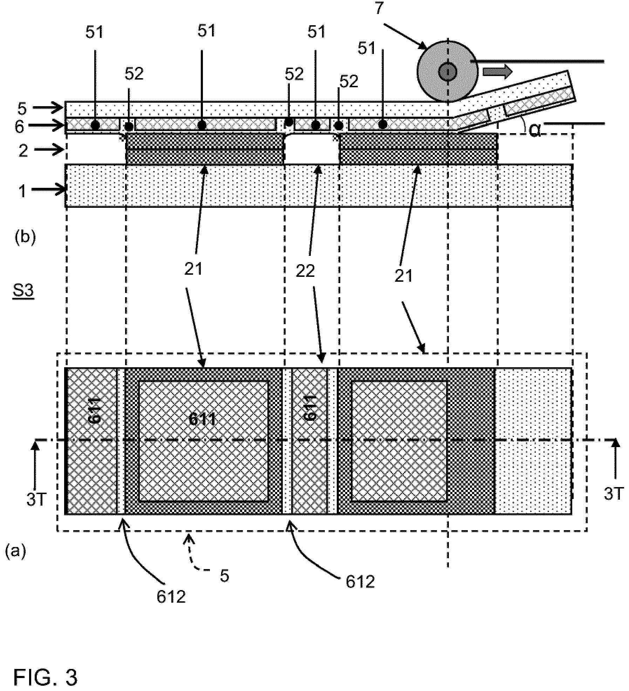

In step S3 as shown in FIG. 3, the film 5 is laminated with a target, wherein the resin layer 6 faces the target.

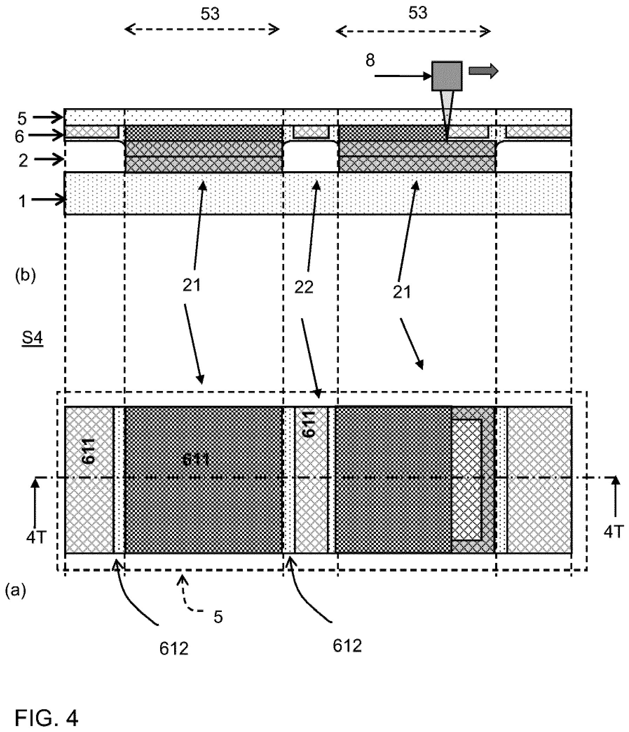

Subsequently, as shown in FIG. 4, the resin layer 62 is fully cured (S4) in at least a third lateral region 53 Therewith the fully cured material in the third lateral region 53 is adhered to the target.

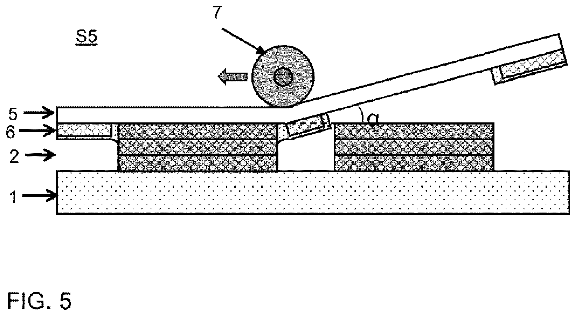

Finally, in step S5, as shown in FIG. 5, the film 5 is delaminated from the substrate. The at least a third lateral region 53 of the resin layer, therewith remains as a new cured resin layer on the target. The remaining resin material which is not adhered to the target is removed together with the film 5 during the lamination.

In this example of the method it is presumed that the target is a semi-finished product which is provided in a preceding step S1 of the method, as schematically shown in part (a) and (b) of FIG. 2. In this example the target is a substrate 1 that carries at least a first patterned layer 2 having elevated sections 21 and recessed sections 22. Boundaries 23 are defined between elevated sections and recessed sections. Part (b) shows the substrate 1 from a side that carries the first patterned layer 2. Part (a) shows a cross-section according to 1B-1B in part (b). The substrate may be any material, e.g. a metal, a glass or a polymer, that is suitable as a carrier for the first patterned layer 2 and any further layers and/or other features thereon. The substrate for example has a thickness in the range of 100 micron to 10 mm, depending on a required stiffness or flexibility. Also any material may be used for the first patterned layer 2, e.g. a metal or a polymer, such as a cured resin, which is for example applied in a preceding step of the improved method. In some embodiments the at least a first patterned layer 2 is one of a plurality of patterned layers.

FIG. 3 shows a laminating step S3 subsequent to step S2, wherein the film 5 is laminated with the substrate 1. Part (a) of FIG. 3 shows a top-view wherein the transparent film 5 is indicated by dotted lines. Part (b) shows a cross-section according to 3T-3T in part (a). Due to the fact that a substantial proportion of the resin on the film is cured, an undesired lateral flow of resin is strongly mitigated.

In the laminating step the resin layer 6 faces the patterned layer 6 on the substrate. As shown in FIG. 3 the first sublayer 61 of the resin layer 6 closest to the radiation transparent film is almost entirely cured. The first sublayer 61 however has substantially uncured second lateral regions 52 between neighboring cured first lateral regions 51.

In a projection transverse to a plane of the substrate, boundaries 23 between elevated sections 21 and recessed sections 22 of the patterned layer 2 are enclosed within the second lateral regions 52. It is noted that first sublayer 61 as provided in step S2 has also a cured first lateral region 51 facing the recessed section 22 of the patterned layer. Therewith the stability of the film 5 is improved an a flow of liquid resin during lamination is further minimized.

Part (a) of FIG. 4 shows a top-view wherein the transparent film 5 is indicated by dotted lines. Part (b) shows a cross-section according to 4T-4T in part (a). In step S4, sections of the resin layer 6 in third lateral regions 53 that coincide with one or more of the elevated sections 21 of the patterned layer 2 are fully cured. Therewith a photon-radiation source 8 is used to irradiate the resin layer 6 in the third lateral regions 53 via the film 5 with a photon energy density and a wavelength that is causes the resin layer to fully cure in the third lateral regions 53. Therewith cured resin material therewith adheres to the elevated sections 21 of the first patterned layer 2.

FIG. 5 shows a delamination step S5, wherein the film 5 is delaminated from the substrate. Therewith the film 5 and resin material thereon outside the third lateral regions 53 is removed from the substrate. The fully cured material of the resin layer, present in the third lateral regions remains at the elevated sections 21 of the patterned layer 2. Due to the fact that the third lateral regions 53 that are to remain with the target and the first lateral regions that are to be removed with the film 5 are mutually separated by uncured resin in the second lateral region 52, it is avoided that this involves shear forces.

As set out above, various approaches are possible to provide S2 a radiation transparent film 5 carrying a resin layer 6 which is partially cured in the sense that a first sublayer 61 thereof closest to the radiation transparent film is at least substantially cured in first lateral regions 51 and that is at least substantially uncured in a second sublayer 62 having a free surface 622 at a side of the resin layer facing away from the radiation transparent film. Examples of these approaches are now described in more detail.

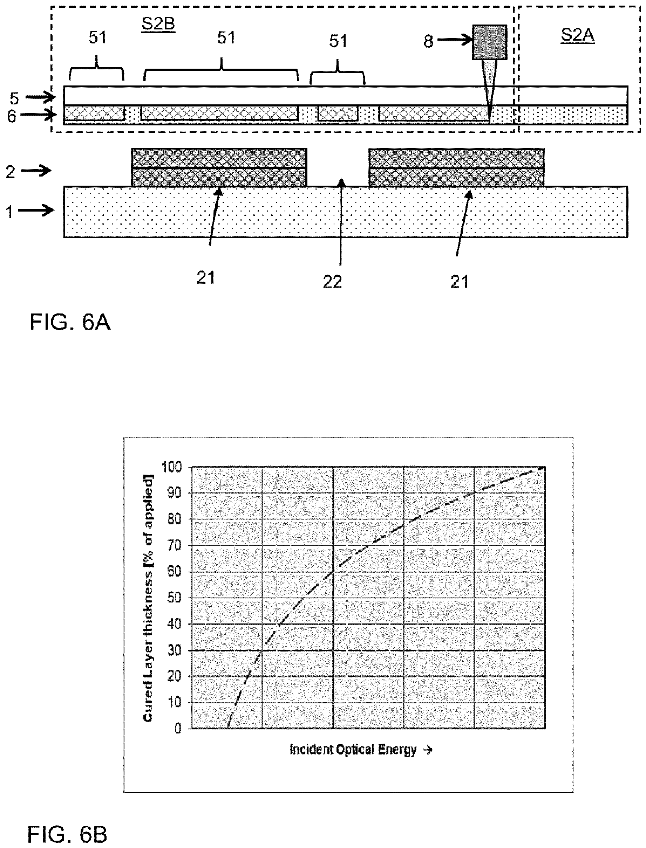

FIG. 6A shows an embodiment wherein the step of providing (S2) a transparent film 5 carrying a resin layer 6 comprises a first sub-step S2A and a second sub-step S2B. In the first sub-step as schematically indicated by a dotted box S2A the film 5 is provided with an uncured resin layer 6. In the second sub-step, indicated by dotted box S2B, photon radiation is directed in the first lateral regions 51 via the film to the uncured resin layer.

FIG. 6B schematically shows the logarithmic relationship between the energy density (J.m$^{-2}$) of the optical radiation applied by photon radiation source 8 via the film to the resin layer and a resulting thickness that is cured therewith. Therein the thickness fraction is indicated as a percentage of the total thickness of the resin layer 6 up to which the resin layer is cured by the optical radiation.

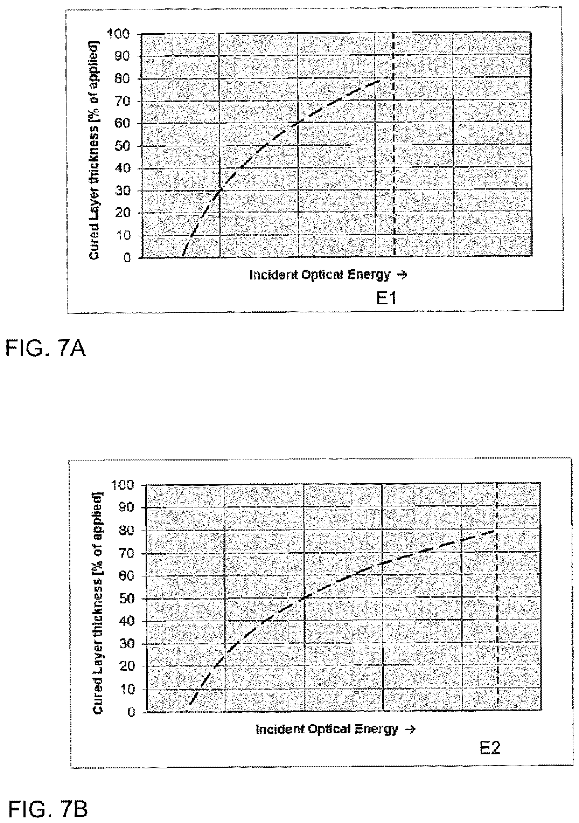

As shown in FIG. 7A, it is achieved that a first sublayer 61 of the resin layer 6 having a thickness which is a fraction of the total thickness of the resin layer 6 is cured in the first lateral regions 51 and a remaining second sublayer 62 is left uncured with an appropriate setting E 1 of the energy density of the photon radiation that is applied via the film to the resin layer. The thickness that is cured therewith is a monotonously increasing function of the energy density, i.e. a monotonously increasing function of the product of the power density and the exposure time. In the example shown the energy density is selected at a value E1 for which 80% of the thickness of the resin layer is cured.

In some examples it may be desired that the dependency of the thickness on the energy density is reduced. As shown in FIG. 7B this can be achieved by adding a photon radiation absorbing agent to the uncured resin. A predetermined curing thickness is now achieved with an energy density E2 that is higher than that in the case of FIG.7A. The slope of the curve is however reduced for this setting, so that any fluctuations in the energy density have less effect on the curing thickness.

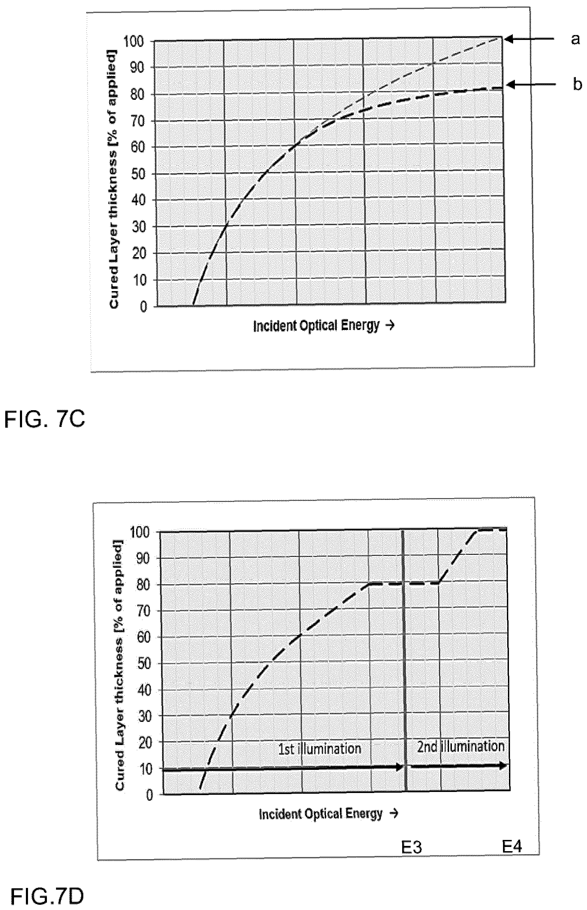

FIG. 7C shows an alternative and/or additional approach of controlling the thickness of curing. In this approach, the resin selected for resin layer 6 is a photocurable polymer having initiators that form radicals upon photodegradation. In this case oxygen is allowed to diffuse into the free surface of the resin layer 6, i.e. opposite the side where the photon radiation is projected via the film. The oxygen that is diffused into a second sublayer of the resin layer near its free surface reacts with the free radicals and thus stops the polymerization chain reaction. The resulting relationship between the energy density and the cured thickness fraction so obtained is indicated by curve b. For comparison, curve a shows the relationship for the case that the process takes place in the absence of oxygen.

FIG. 7D shows still further approach. In this case the uncured resin layer 6 on the film 5 is provided as first sub-layer 611 and a second sub-layer 612 with mutually different curing requirements. In this example the critical optical energy density of the second sub-layer 612 is higher than that of the first sub-layer 611. As illustrated in FIG. 7D, an exposure with an energy density E3 at the side of the film 5 results in a full curing of the first sub-layer 611 in the first lateral regions, while the second sub-layer 612 is left uncured. Subsequent to lamination in step S3 third lateral regions 53 that coincide with one or more of the elevated sections 21 of the patterned layer 2 are exposed via the film with photon radiation having a higher energy density E4 to fully cure (S4) the sections of the resin layer 6 in these lateral regions 53.

In another embodiment using this approach, the first sub-layer 611 and the second sub-layer 612 are of a photocurable polymers that are sensitive to a first and a second mutually different photon-radiation wavelength. In this embodiment step S2B is performed by directing photon radiation with first wavelength in the first lateral regions 51 via the film to the uncured resin layer. Therewith the first sub-layer 611 is cured in the first sub-layer 611, whereas the second sub-layer 612 remains uncured. Subsequent to lamination in step S3 third lateral regions 53 that coincide with one or more of the elevated sections 21 of the patterned layer 2 are exposed via the film with photon radiation having the second wavelength to fully cure (S4) the sections of the resin layer 6 in these lateral regions 53.

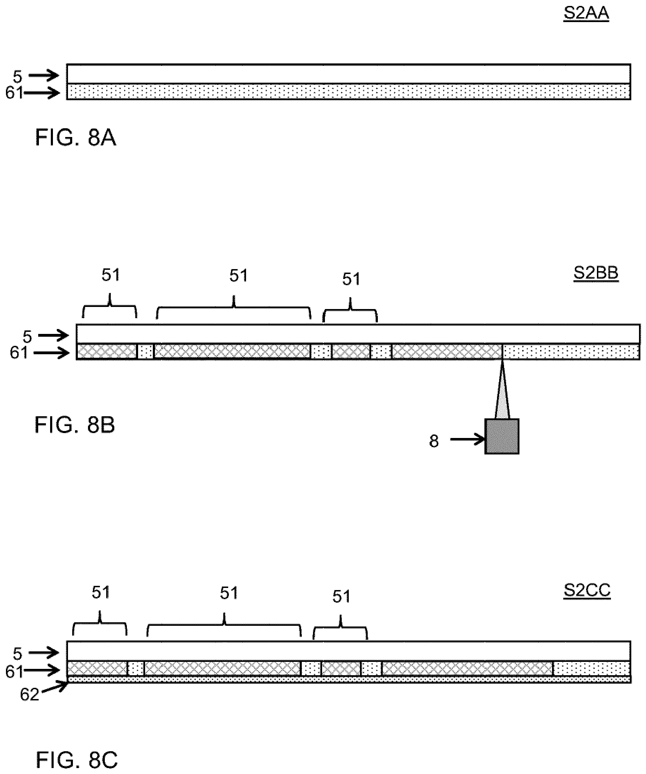

A still further embodiment is described with reference to FIG. 8A-8C. In a first sub-step S2AA of step S2, as shown in FIG. 8A, a radiation transparent film 5 is provided that carries a first sublayer 61 of an uncured resin. In a second sub-step S2BB of step S2, as shown in FIG. 8B, photon radiation of a photon-radiation source 8 is directed to first lateral regions 51 of the first sublayer 61. Therewith the first sublayer 61 is cured in the first lateral regions 51. As shown in FIG. 8B, it is not necessary in this embodiment that the photon radiation is directed via the film 5. Subsequently, in step S2CC, a second sublayer 62 of an uncured resin is deposited on the free surface of the first sublayer 61. Therewith a radiation transparent film 5 is obtained that carries a resin layer 6 which in a first sublayer 61 thereof closest to the radiation transparent film is at least substantially cured in first lateral regions 51 and is at least substantially uncured in second lateral regions 52 outside the first lateral regions, and which resin layer 6 is also at least substantially uncured in a second sublayer 62 thereof having a free surface 622 at a side of the resin layer facing away from the radiation transparent film. Together with the substrate obtained in step S1, this film can be used in the further steps S3-S5 described with reference to FIG. 3-5.

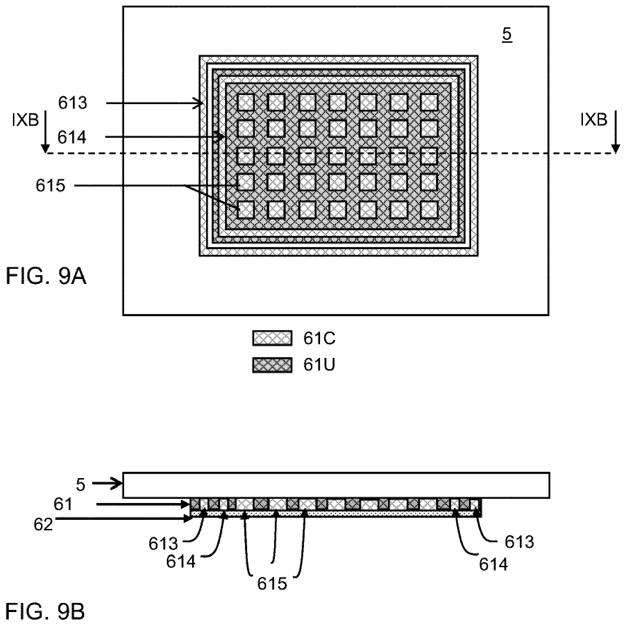

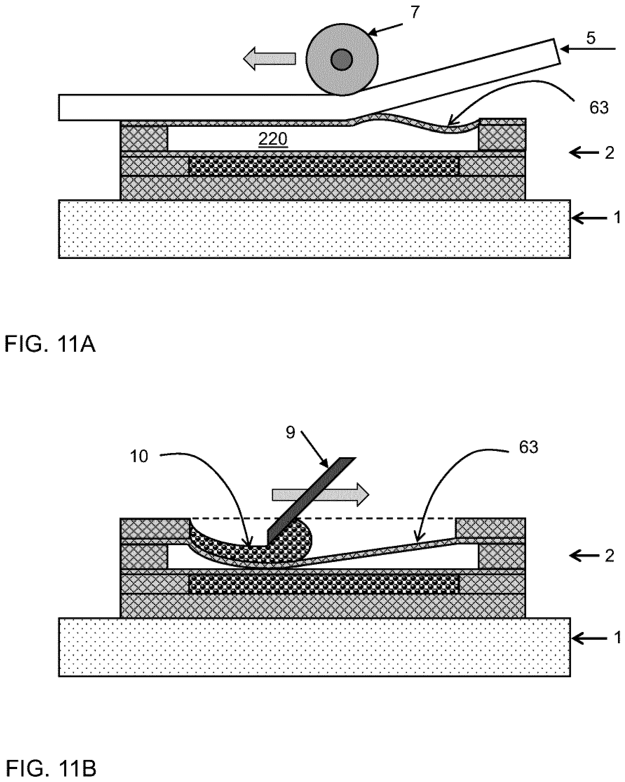

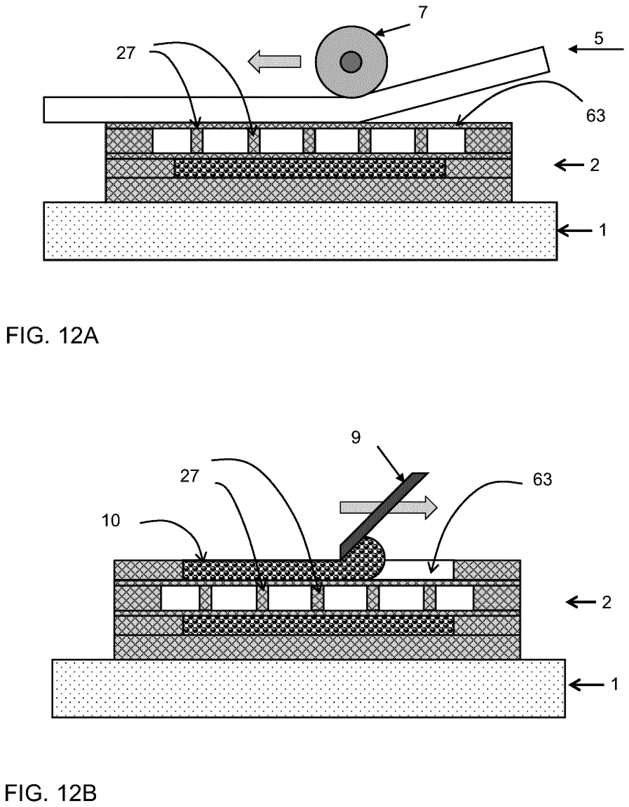

FIG. 9A and 9B show an example of a film 5 obtained in step S2. FIG. 9B is a cross-section according to IXB-IXB in FIG. 9A. Material in the first sublayer 61 that is cured is indicated by light cross-hatching 61C and material that is not (yet) cured is indicated by dark cross-hatching 61U. In this example a first sublayer 61 of the resin layer on the film 5 is at least substantially cured in lateral sections 613, 614 and 615. The second sublayer 62 is not yet cured. Lateral sections 613 and 614 each form a round going wall. Round going wall 613 encloses round going wall 614, and round going wall 614 encloses an area that has at least one region of uncured resin in the first sublayer 61. The area enclosed by the round going wall 614 comprises cured subregion 615 enclosed by uncured resin. The cured subregions 615 form pillars. The pillars 615 can be used to control the layer thickness. The pillars 615 mitigate a flow of uncured resin during a subsequent lamination, but allow for a diffusion of photo-initiators in the uncured resin enclosed by the round going wall in the direction of the free surface of the resin layer to facilitate further curing subsequent to lamination. This is in particular advantageous for embodiments wherein oxygen inhibition is used to inhibit curing of the resin layer near its free surface. In subsequent manufacturing stages the pillars 615 may also be relevant for supporting a membrane as will be clarified by the examples in FIG. 11A, 11B and 12A, 12B.

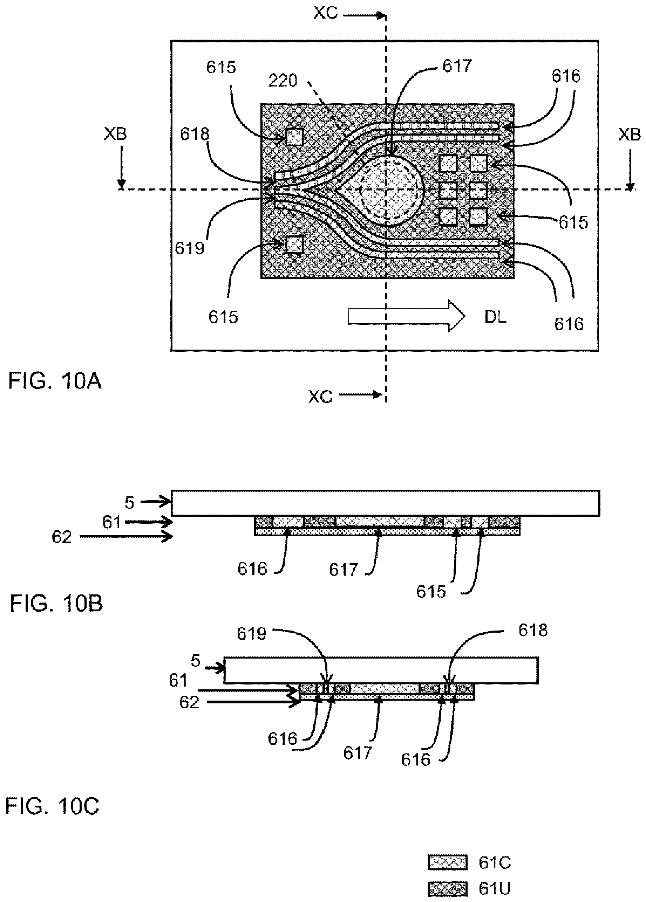

FIG. 10A, 10B and 10C show another example of a film 5 obtained in step S2. FIG. 10B is a cross-section according to XB-XB in FIG. 10A and FIG. 10C is a cross-section according to XC-XC in FIG. 10A. In this example, the lateral region 617 is cured region in the first sublayer 61 that is to overlap a recessed region (indicated by a dotted circle 220) in previous deposited layer to form a cavity. Also a first and a second channel 618, 619 are formed that substantially extend in a direction corresponding to a direction of laminating DL in the subsequent lamination step S3, each at a respective side of the lateral region 617. The channels 618, 619 are each bounded by a pair of walls 616, formed by cured resin material in the first sublayer 61.

During lamination in the subsequent lamination step S3, the channels 618, 619 contribute to a controlled flow of uncured resin during lamination. Liquid resin is directed away from the recessed region 220 in the preceding layer that is to be overlapped to form a cavity. Therewith a flow of liquid resin into the recessed region is mitigated. Whereas a flow of liquid resin is still possible in the second sublayer 62 which is still uncured during lamination, the flow resistance for uncured resin within the channels is low as compared to a flow resistance for uncured resin in the second sublayer 62 due to the fact that the 62 has a comparatively small thickness as compared to that of the first sublayer 61.

As shown in FIG. 11A, 11B in some examples a cavity 220 may be desired that is overlapped by a thin membrane 63 of cured resin. In the example of FIG. 11A, a step is shown wherein the membrane 63 is delaminated from the film 5. As shown therein there is a risk that the membrane 63 is deformed during this step if it is relatively thin. Also, it may be complicated to perform other subsequent steps, such as a step wherein a conductive material 10 is applied with a doctors blade 9. Also a deformation of the membrane 93 may occur due to the pressure exerted by the blade 9.

As indicated above, a deformation of the membrane 93 can be avoided by a reinforcement of the preceding layer with pillar like elements 27. This is shown in FIG. 12A and 12B. The pillars 27 are formed in a preceding step as shown in FIG. 9A and 9B and correspond to elements 615 therein. FIG. 12A and 12B illustrate that the pillars 27 provide support for the membrane 63 during delamination and during other processing steps.

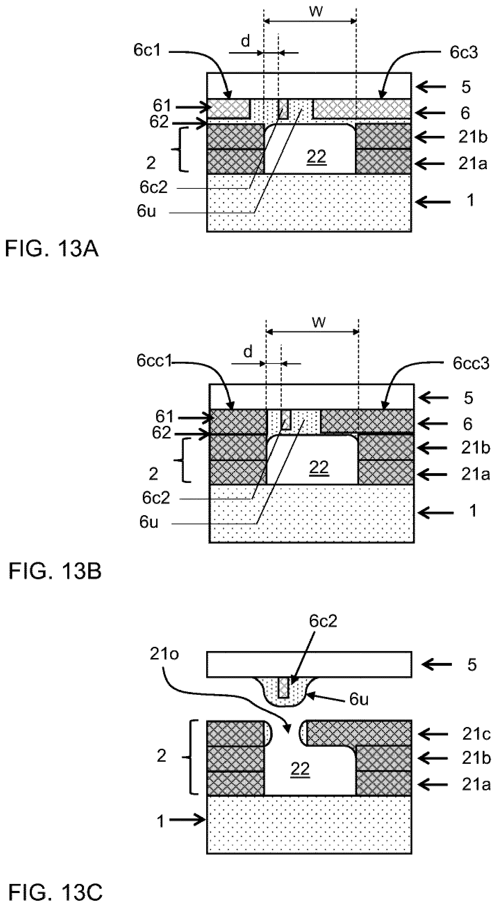

FIG. 13A, 13B and 13C illustrate show subsequent steps of an embodiment of the improved method used to deposit a layer with a through hole.

FIG. 13A shows the result of a step S3, as described for example with reference to FIG. 3, wherein a film 5 carrying a resin layer 6 was laminated onto a first patterned layer 2 provided on a substrate 1. The resin layer 6 has a first sublayer 61 with cured lateral sections 6c1, 6c2, 6c3, and an uncured lateral section 6u that surrounds the cured lateral section 6c2. The relatively thin second sublayer 62 is not cured yet. As shown in FIG. 13A, the previously deposited layers, together indicated with reference numeral 2 have elevated sections 21a, 21b that form a wall around a recessed section 22 having a width w. The cured lateral sections 6c1 and 6c3 of the first sublayer 61 of the resin layer is to form a cover over the recessed section 22. The cured lateral sections 6c2 is to be removed in de subsequent delamination step, so as to form a through hole. As can be seen in FIG. 13A, the cured lateral section 6c2 is at a distance d from a side of the elevated section 21a.

In a subsequent step, as illustrated in FIG. 13B, third lateral sections 6cc1, 6cc2 of the resin layer 6 coinciding with the elevated sections 21a, 21b of the first patterned layer 2 are fully cured. I.e. also the second sublayer 62 is cured in the third lateral sections. The area of the third lateral sections substantially corresponds to the area of the cured lateral sections 6c1 and 6c3. However, the lateral sections 6c1, 6c3 in FIG. 13A are slightly smaller than the fully cured third lateral sections 6cc1, 6cc3 in FIG. 13B, to take into account lateral shifts that may occur during the lamination step. Once lamination is completed the further curing step S4 as clarified for example in FIG. 4 is applied to fully cure the third lateral sections of the resin layer (6) that are to remain with the target.

Subsequently, as shown in FIG. 13C, the film 5 is delaminated from the first patterned layer 2. Therewith the fully cured lateral sections 6cc1, 6cc3 of the resin layer 6 remain as a further elevated sections 21c on the elevated sections 21a, 21b of the first patterned layer 2 that were deposited in preceding iterations. The cured lateral section 6c2 however is easily delaminated together with the film 5 from the semi-finished product. This is achieved in that the surrounding uncured material 6u avoids friction between the cured portions 21c that are to remain with the product and the cured lateral section 6c2 that is to be removed together with the film 5. Therewith a cavity 22 is formed with a cover layer 21c defining an opening 21o.

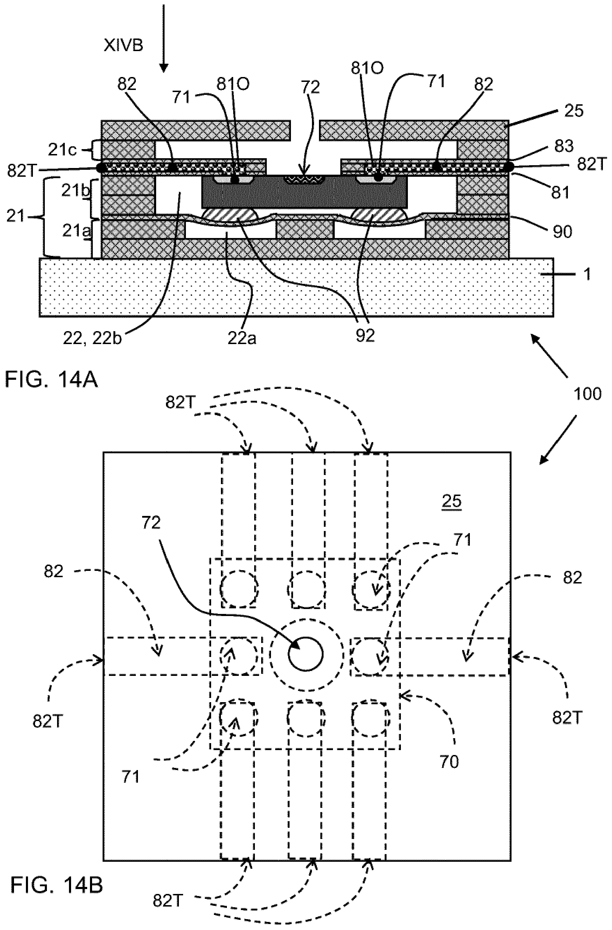

FIG. 14A and 14B show a chip package 100. Therein FIG. 14B is a top-view according to XIVB in FIG. 13A, wherein some hidden elements are indicated by dashed lines. As clarified below, the chip package 100 was obtained with a chip packaging method using steps of the improved method.

The chip package 100 comprises a package bottom layer 1 corresponding to the substrate 1 of step S1 of the method. The package bottom layer 1 carries a chip 70 that has at least one electronic component and electric terminals 71 at a first side facing away from the bottom layer. The package bottom layer further carries a patterned layer that has an elevated section 21 and a recessed section 22. The chip 70 is accommodated in the recessed section 22 and is circumferentially enclosed by the elevated section 21.

The chip package 100 comprises a first and a second connector membrane layer 81, 83 that extends over the first side of the chip 70 and the elevated section 21 of the patterned layer. Conductor lines 82 of an electrically conductive material are sandwiched between the first connector membrane layer 81 and the second connector membrane layer 83. The conductor lines electrically connect respective ones of the electric terminals 71 with respective package terminals 82T. To that end openings 810 are provided in the first connector membrane layer 81 that wherein the conductor lines 82 are electrically connected to respective ones of the electric terminals 71 of the chip.

In the embodiment shown the chip 70 is suspended by a flexible membrane 90 to which it is adhered with adhesive means 92. Therewith the chip 70 is protected against mechanical stress that could potentially occur during curing of elements in the package. The flexible membrane 90 is provided on an elevated section 21a of a first patterned layer on the substrate 1. A second patterned sublayer having an elevated section 21b and a recessed section 22b is formed on the first flexible membrane 90. The elevated section 21b of the second patterned sublayer is supported by the elevated section 21a of the first patterned sublayer via the first flexible membrane 90. The chip package 100 further comprises a cover layer 25 that is supported by an elevated section 21c formed on the second connector membrane layer 83. As shown in FIG. 13A, 13B, in this embodiment, the cover layer 25 and the first connector membrane layer 81 and the second connector membrane layer 83 define an opening that gives access to a sensor element 72 on the chip 70. The sensor element 72 is for example an acoustic sensor for sensing sound signals or a chemical sensor for sensing chemical substances in the environment.

The improved methods according to the present disclosure are very suitable to manufacture the chip package 100 of FIG. 14A, 14B as is set out below.

First a substrate 1 provided with a first patterned layer 2 is provided having elevated sections 21a defining a circumference of a side wall according to step S1 described with reference to FIG. 2 for example. Then the membrane layer 90 is provided thereon with the steps S2-S5 described with reference to FIG. 2-5.

Subsequently further patterned layers are deposited on the flexible membrane 90. Elevated sections 21b provide a further extension of the side wall of the chip package 100. Subsequently, the chip 70 is adhered to the flexible membrane 90 with adhesive means 92.

The steps S2-S5 shown in FIG. 2 - 5 are used to deposit a first connector membrane layer 81 that extends over the first side of the chip and the elevated section 21b of the patterned layer 2 and that defines openings 810 that give access to respective electric terminals 71 of the chip 70. Then conductor lines 82 of an electrically conductive material are deposited on the first connector membrane layer 81 to electrically connect each of the electric terminals 71 with a respective package terminal 82T. For that purpose an electrically conductive paste or ink may be used that is cured subsequent to its deposition.

Subsequently the steps S2-S5 shown in FIG. 2 - 5 are used to deposit a second connector membrane layer 83 on the first connector membrane layer 81 with the conductor lines 82. Therewith the conductor lines are sandwiched between the first connector membrane layer and the second connector membrane layer.

Finally a further patterned layer having an elevated section 21c that is supported by the elevated section 21b of the second patterned sublayer via the connector membrane layers 81,83 as well as cover layer 25 are applied with the steps S2-S5 shown in FIG. 2 - 5.

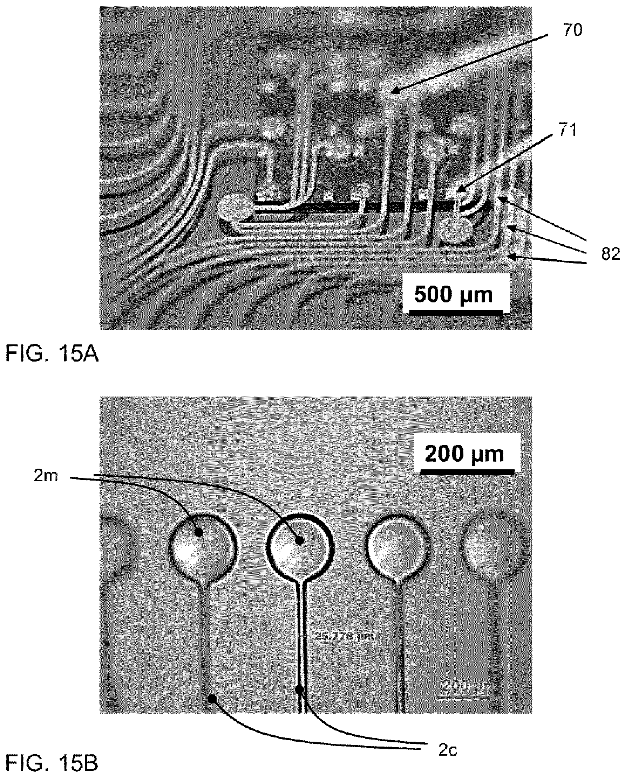

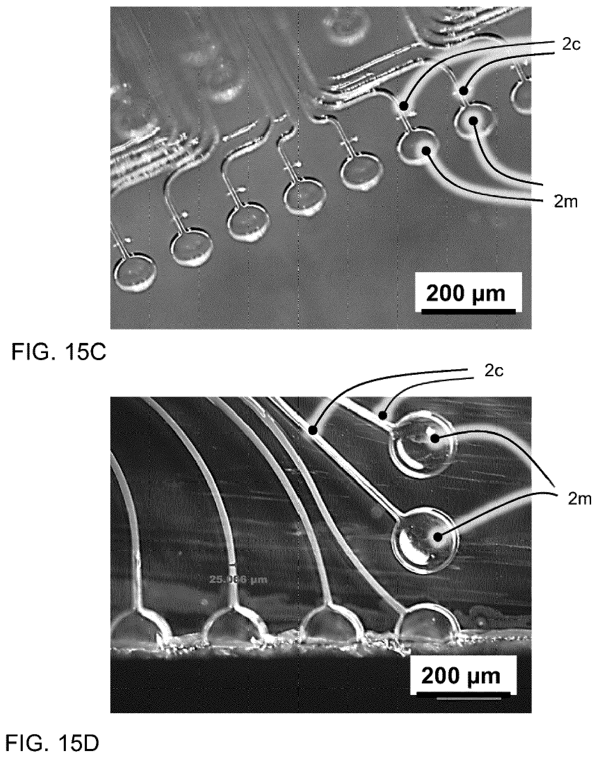

FIG. 15A-15D shows exemplary applications. FIG. 15A shows a high-resolution chip fanout structure with conductor lines 82 to respective electric terminals 71 of a chip 70. FIG. 15B, 15C and 15D show examples of 25 micron wide micro-fluidic channels 2c into cavities covered with a 15 micron thick membrane 2m.

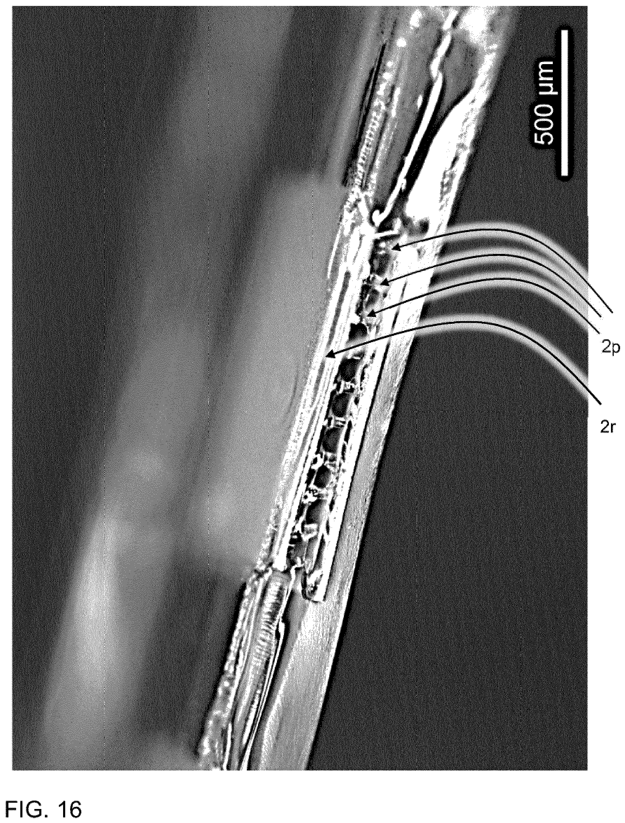

FIG. 16 shows a cavity having a cover 2r that is supported by pillars 2p and that accommodates an RF antenna.

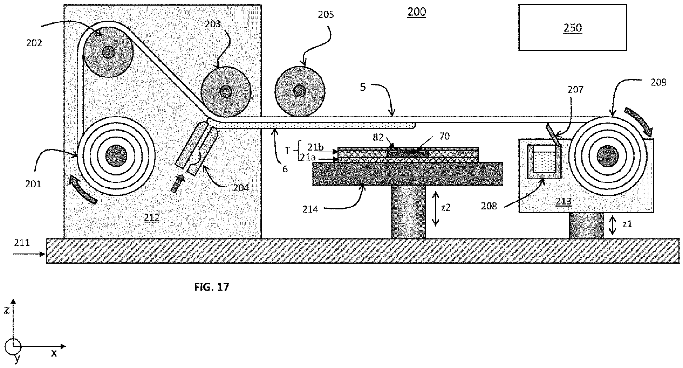

Manufacturing equipment is now described in more detail with reference to FIG. 17 to FIG. 29. Typically the operation of the various means thereof is controlled by a controller 250. The controller 250 may be provided as dedicated hardware, a suitably programmed general purpose processor, a PLL or a combination thereof.

FIG. 17 schematically shows a manufacturing apparatus 200 comprising amongst others an unwind roller 201, a web tension control drum 202, a counter drum 203 that guides the film 5 along a slot die coating head 204. In the example shown, the unwind roller 201, the web tension control drum 202, the counter drum 203 and the slot die coating head 204 are accommodated in a stationary frame 212, i.e. stationary arranged on a base plate 211. FIG. 17 also shows that the manufacturing apparatus 200 comprises a variable height frame 213 accommodating a rewind roller 209 a scraper blade 207 and a collection reservoir 208. The variable height frame 213 is configured to be controllably positioned at a height z1. Additionally the manufacturing apparatus 200 comprises a building platform 214 that is controllably positioned at a height z2 between the stationary frame 212 and the variable height frame 213 . In the example shown the building platform 214 carries a target T. In this case the target T comprises previously deposited layers 21a, 21b, wherein a chip 70 is embedded. Furthermore a pattern of a curable electrically conductive material 82 is deposited in order to provide electrical connections to the chip 70. The stationary frame 212, the variable height frame 213 and the controllably positionable building platform 214 are arranged on the fixed base plate 211. FIG. 17 further illustrates how the coating head 204 deposits a layer 6 of a curable resin on a surface of the film 5 facing the target T.

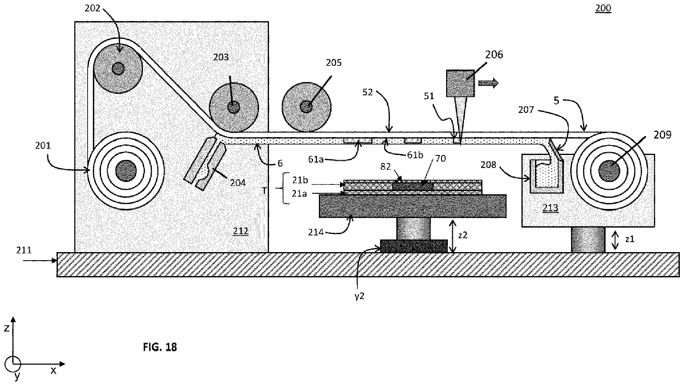

FIG. 18 shows the manufacturing apparatus 200 in operation to perform a further step, pre-curing step, using a controllable light source 206. The light source 206 is controlled to direct photon radiation via the film to the uncured resin layer in first lateral regions 51. A wavelength and an intensity of the radiation are selected in relation to a thickness and transmission characteristics of the resin layer to achieve that cured lateral sections 61a are formed in the irradiated first lateral regions 51 of the resin layer 6. The cured lateral sections 61a do not extend over the full depth of the resin layer, but only extend within a first resin sublayer of the resin layer 6 at the side of the film 5. A second, remaining sublayer of the resin layer, at a side away from the film 5 remains uncured. In second lateral regions 52 where the resin layer 6 is not irradiated by the controllable light source 206 the resin layer 6 remains uncured over its full depth.

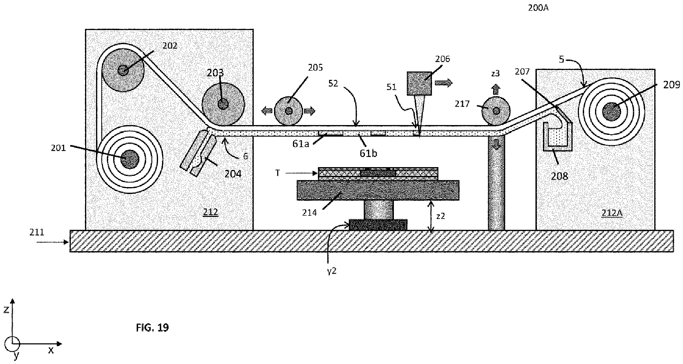

FIG. 19 shows an example of another embodiment 200A of the manufacturing apparatus. In this case the variable height frame 213 of the apparatus 200 of FIG. 17,18 is replaced with a fixed height frame 212A. Instead a controllable height guidance roller 217 is provided of which a height z3 is controllable. In the example shown the another embodiment of the manufacturing apparatus 200A performs a pre-curing step in a manner similar as shown in FIG. 18.

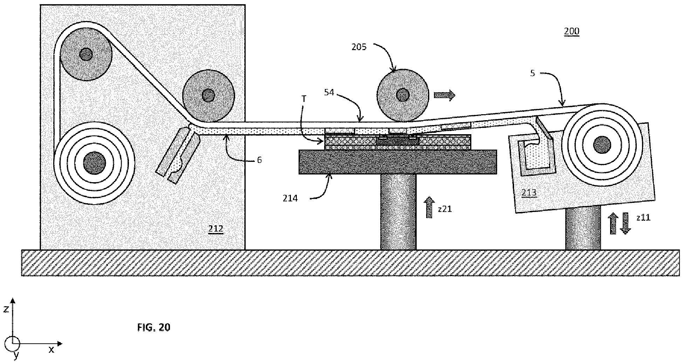

FIG. 20 shows the apparatus 200 of FIG. 17, 18 in the operational stage of performing a step of laminating the film 5 carrying the partially cured resin layer 6 with the target T. Therewith the variable height frame 213 is lifted to a height z11 so that the film 5 is pulled slightly upwards at the side of the variable height frame 213. Also the building platform 214 is lifted to a level z21, and the lamination/delamination roller 205 is rolled over a free surface 54 of the film 5 to laminate the film with the target T.

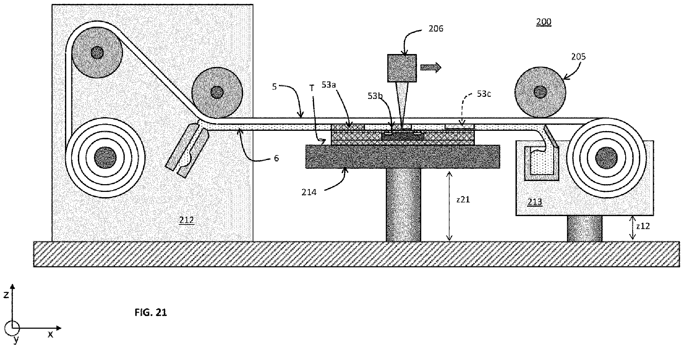

FIG. 21 shows the apparatus 200 in a further operational stage wherein the controllable light source 206 irradiates a third lateral region 53b to fully cure the resin layer 6 therein. In the third lateral region 53a the resin layer is already fully cured, and the controllable light source 206 moves in the x-direction so as to also fully cure the resin layer 6 in the third lateral region 53c.

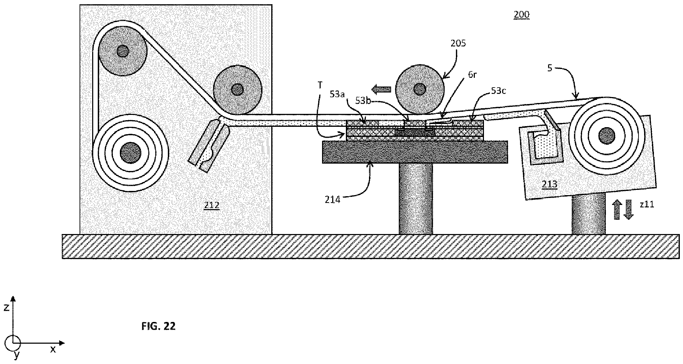

FIG. 22 shows the manufacturing apparatus 200 while performing the step of delaminating S5 the film 5 from the target T. To that end the variable height frame 213 is lifted to a position z11 and the lamination/delamination roller 205 is rolled in a direction -x. As a result of the delamination, the film 5 and resin material 6r thereon outside the third lateral region 53a, 53b, 53c that were fully cured is removed from the target. The fully cured resin material present in the third lateral region 53a, 53b, 53c remains on the target T to form an additional patterned layer.

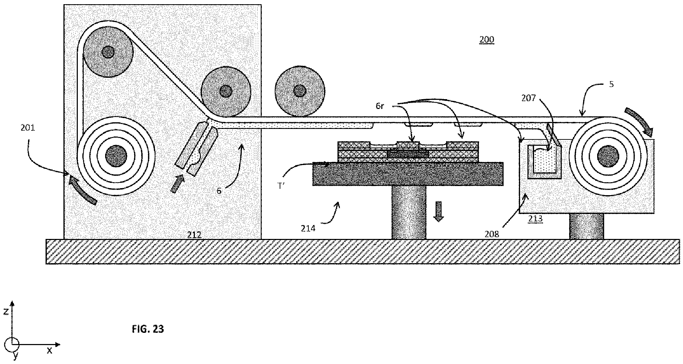

FIG. 23 shows the manufacturing apparatus 200 upon completion of the delamination. The film 5 is now transported in the direction x, and the scraper blade 207 removes residual resin material 6r from its surface, for collection in the collection reservoir 208. While transporting the film 5 a new layer 6 of curable resin is deposited on the film 5 supplied from unwind roller 201. The platform 214 is lowered to fully separate the target, now denoted as T' from the film 5. The building platform 214 with the target T' may now be transported in a direction y for applying further processing steps thereto.

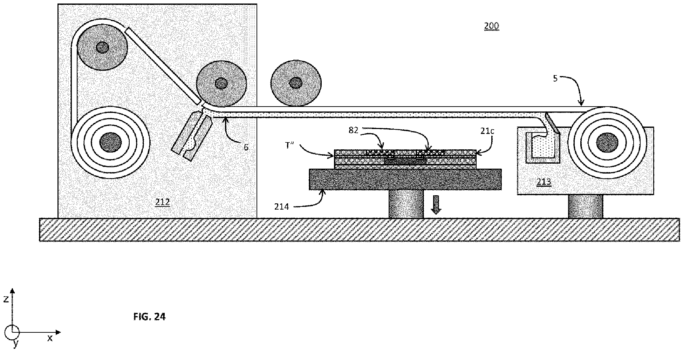

FIG. 24 shows by way of example the situation wherein an applied further processing step is the deposition of a curable electrically conductive material 82 in trenches defined by the patterned layer 21c in the target T', therewith providing a target T". In the meantime, the film 5 is now fully cladded with a continuous layer 6 of curable resin material, so that the apparatus 200 can proceed to repeat the steps as described with reference to FIG. 18, 20, 21, 22 and 23 in order to add one or more further patterned layers to the target.

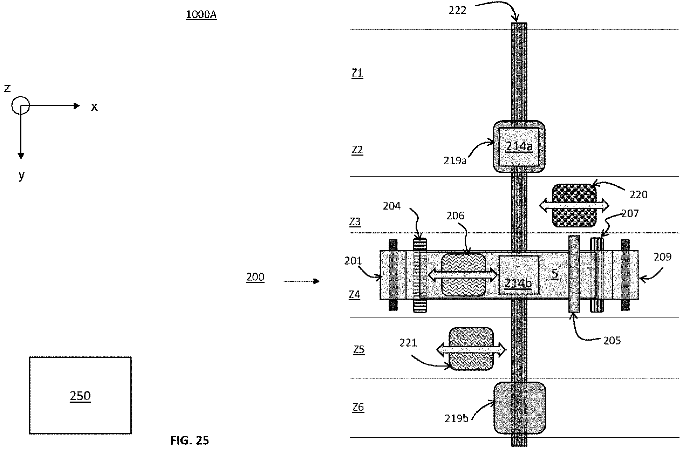

FIG. 25 shows an example wherein the apparatus 200 is incorporated in a manufacturing arrangement 1000A. The manufacturing arrangement 1000A has six zones Z1,...,Z6, and the manufacturing apparatus 200 is arranged in zone Z4. The manufacturing arrangement 1000A comprises a pair of a first building platform 214a and a second building platform 214b that are moveable along a common track 222 in the direction y. The manufacturing arrangement 1000A further has a second manufacturing zone Z2 and a sixth manufacturing zone Z6 in each of which a respective thermal curing & solvent extraction station 219a, 219b is arranged. In the example shown in FIG. 25, the first building platform 214a is momentarily positioned within thermal curing & solvent extraction station 219a and the second building platform 214b is momentarily positioned in zone Z4, in order to enable the manufacturing apparatus 200 to deposit a new patterned layer on the target carried by the second platform. In addition the manufacturing arrangement 1000A has a cleaning & filling station 220 that is movably arranged in the x-direction within third manufacturing zone Z3 and a pick & place device 221 which is arranged in the fifth manufacturing zone Z5, also movably arranged in the x-direction. The cleaning & filling station 220 is for example configured to clean a target on a building platform 214a, 214b for example to remove dust or remainders of uncured material therefrom. The cleaning & filling station 220 is for example also configured to deposit curable liquid substances on the target, e.g. in trenches defined by a patterned layer thereof, for example comprising an electrically conductive substance, an electrically insulating substance, a thermally conductive substance or a thermally insulating substance. The deposited substance may subsequently be cured in one of the thermal curing & solvent extraction stations 219a, 219b.

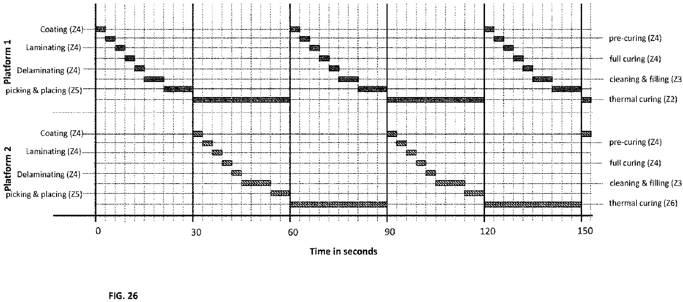

An exemplary scheduling of various processing steps performed by the manufacturing arrangement 1000A is illustrated in FIG. 26. As shown therein, the first building platform 214a is positioned in zone Z4 to subsequently perform coating (See FIG. 17), pre-curing (See FIG. 18), laminating (See FIG. 20), full curing (See FIG. 21) and delaminating (See FIG. 22). Then the first building platform 214a is transported along the y-axis to cleaning & filling station 220 in zone Z3 to perform cleaning and filling, for example cleaning to remove residuals of the curable resin and filling to deposit an electrically conductive substance. Then the first building platform 214a is transported along the y-axis to zone Z5, so that the pick & place device 221 can place a component (e.g. a chip) to be integrated in the target. Subsequently the first building platform 214a is transported along the y-axis to zone Z2 to enable the thermal curing & solvent extraction station 219a to cure the substance that was deposited in zone Z3. While the first building platform 214a remains in zone Z2, the second building platform 214b is moved along the y-axis to zone Z4 to subsequently perform coating, pre-curing, laminating, full curing and delaminating to the target on this platform. Likewise the steps of cleaning and filling are performed in zone Z3 and picking and placing in zone Z5. Subsequent to these steps the second building platform 214b is transported to the sixth manufacturing zone Z6 to enable the thermal curing & solvent extraction station 219b to cure the substance that was deposited in zone Z3. The fact that the second building platform 214b is assigned a proper thermal curing & solvent extraction station 219b renders it possible to transport the first building platform 214a along the same axis towards the fourth manufacturing zone Z4 to enable the manufacturing apparatus 200 to deposit a new patterned layer on the target on the first building platform 214a. As shown in FIG. 26 the processing steps performed in the zones Z3, Z4 and Z5 can be repeated for a target on a first one of the platforms 214a, 214b while the target on the other one of the platforms 214b, 214a is subjected to a thermal curing & solvent extraction process.

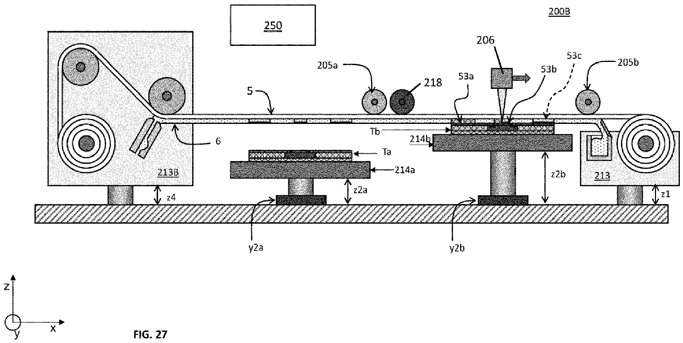

FIG. 27 shows a still further embodiment 200B of the manufacturing apparatus. In comparison to the manufacturing apparatus 200 of FIG. 17, 18, the stationary frame 212 is replaced with a variable height frame 213B that is configured to be controllably positioned at a height z1. Furthermore the manufacturing apparatus 200B is provided with a pair of a first building platform 214a and a second building platform 214b that each carry a respective target Ta, Tb representing a product to be manufactured. In the operational stage shown in FIG. 20, the controllable light source 206 irradiates a third lateral region 53b to fully cure the resin layer 6 therein. In the third lateral region 53a the resin layer is already fully cured, and the controllable light source 206 moves in the x-direction so as to also fully cure the resin layer 6 in the third lateral region 53c. A further guidance roller 218 is provided at a fixed position.

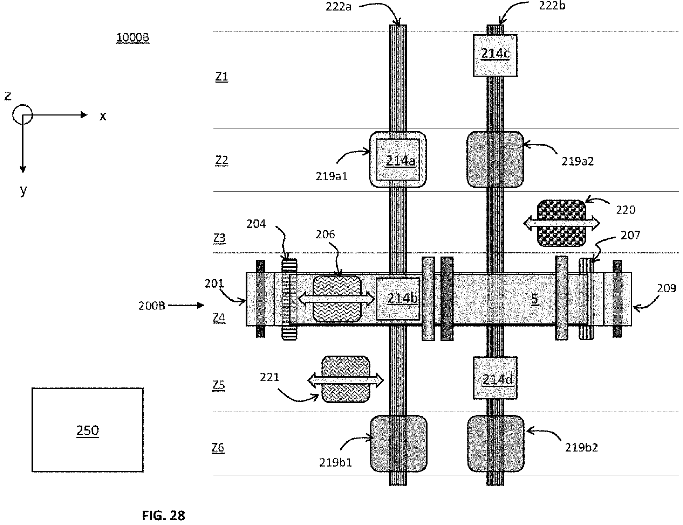

FIG. 28 shows an example wherein the apparatus 200B of FIG. 27 is incorporated in a manufacturing arrangement 1000B. The manufacturing arrangement has six manufacturing zones Z1,..,Z6 corresponding to those in the arrangement 1000A in FIG. 25. Contrary to the arrangement 1000A has a pair of a first track 222a and a second track 222b both extending in the y-direction. As in the arrangement 1000A a first building platform 214a and a second building platform 214b are movable independent from each other along the first track 222a. Similarly, a pair of a third building platform 214c and a fourth building platform 214d is provided that are movable independent from each other along the second track 222b.

In the zone Z2, the manufacturing arrangement 1000B has a first thermal curing & solvent extraction station 219a1 arranged along the first track 222a and a second thermal curing & solvent extraction station 219a2 along the second track 222b. Likewise, in zone Z6, the manufacturing arrangement 1000B has a third thermal curing & solvent extraction station 219b1 arranged along the first track 222a and a fourth thermal curing & solvent extraction station 219b2 arranged along the second track 222b. A manufacturing apparatus 200B as shown in FIG. 27 is arranged in the fourth zone Z4.

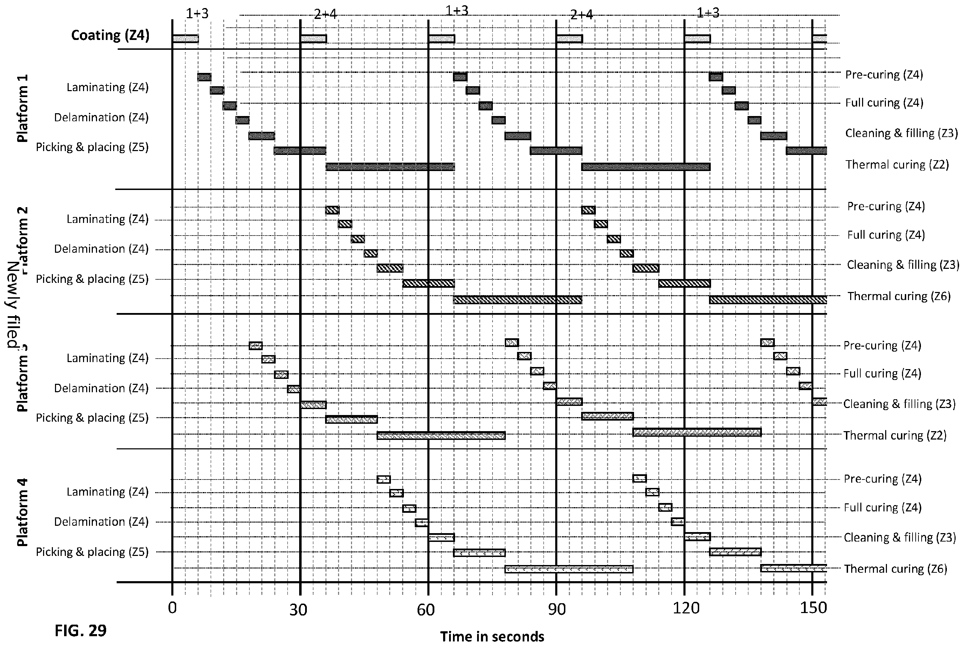

As shown in FIG. 29, this manufacturing arrangement 1000B enables an even more efficient scheduling of the production process. Therein a common coating process of curable resin is performed in zone Z4 for use with platforms 1 +3 and for use with platforms 2+4. In other words, and wherein the deposition device 204 is configured to deposit the uncured resin layer 6 over a length of the film 5 extending over the first and the second track in a single cycle. For each platform individually the schedule substantially corresponds to that of a platform in the arrangement 1000A in FIG. 25 according to the schedule presented in FIG. 26. However, the combined schedule for the four platforms is now more efficient due to the fact that the coating step is combined for the production process of the targets on platforms 214a,214c, and also for the platforms 214b, 214d. With the manufacturing arrangement 1000B using the manufacturing apparatus 200B double the number of completed deposition cycles per unit of time with a single slot die coating device.

**Claims**

1. A method of manufacturing a layered 3D product, the method comprising adding a layer with steps comprising:

   providing (S2) a radiation transparent film (5) carrying a resin layer (6) which in a first sublayer (61) is at least substantially cured in at least a first lateral region (51), and which resin layer (6) is at least substantially uncured in a second sublayer (62) thereof that has a free surface (622) at a side of the resin layer facing away from the radiation transparent film;

laminating (S3) the film (5) with a target, wherein the resin layer (6) faces the target;

fully curing (S4) the resin layer (6) in at least a third lateral region (53);

delaminating (S5) the film (5) from the substrate, therewith removing the film (5) and resin material thereon outside the at least a third lateral region (53) from the target, and leaving the fully cured material of the resin layer present in the at least a third lateral region on the target.

2. The method of manufacturing a layered 3D product according to claim 1, wherein the first sublayer (61) comprises at least a substantially uncured second lateral regions (52) between a first lateral region that is to be removed with the film during delaminating, and another first lateral region that is to remain at the target subsequent to said delaminating.

3. The method according to claim 2, wherein the second lateral regions (52) have a width exceeding twice a positioning tolerance in the step of laminating the film (5) with the substrate (1).

4. The method according to either of the preceding claims, wherein the step of providing (S2) a transparent film (5) carrying a resin layer (6) comprises:

   providing (S2A) the film (5) with a layer (6) of an uncured resin; and

   in said first lateral regions (51) directing (S2B) photon radiation via the film to the uncured resin layer, wherein a wavelength and an intensity of the radiation are selected in relation to a thickness and transmission characteristics of the resin layer to achieve that therein the first resin sublayer (61) having cured lateral sections (611) in first lateral regions (51) is formed and that resin material in the second resin sublayer (62) remains uncured.

5. The method of claim 4, wherein the step of directing (S2B) photon radiation is performed in the presence of oxygen.

6. The method according to claim 4 or 5, wherein the first sub-step of providing the film (5) with an uncured resin layer (6) comprises providing the uncured resin layer (6) as first sub-layer (611) and a second sub-layer (612) with mutually different curing requirements.

7. The method according to claim 6, wherein the mutually different curing requirements of the first sublayer (611) and the second sub-layer (612) comprise a mutually different photon-radiation wavelength required to initiate curing.

8. The method according to either of the claims 4-7, comprising an intermediate step succeeding the step of providing (S2) a radiation transparent film (5) carrying a resin layer (6) and preceding the step of laminating (S3), the intermediate step comprising partially removing the uncured photocurable resin from the film (5).

9. The method according to either of the preceding claims, wherein a magnitude of a surface tension of the uncured resin is lower than a magnitude of a surface energy of the film on which it is provided.

10. The method according to one or more of the preceding claims, wherein at least one lateral section of the resin layer (6) is provided with a round going wall which is cured while at least one region in an area enclosed by the round going wall is left uncured.

11. The method according to claim 10, wherein the area enclosed by the round going wall comprises at least one cured subregion enclosed by uncured resin.

12. The method according to one or more of the preceding claims, wherein one or more uncured second lateral regions of the first sublayer (61) of the resin layer are provided as channels that substantially extend in a direction corresponding to a direction of laminating.

13. The method of claim 1, wherein the target comprises a substrate carrying a first patterned layer that has laterally distributed pillar shaped elements within a recessed section and wherein a lateral section of the resin film that is to face the recessed section is precured in its entirety.

14. A chip packaging method, comprising:

Providing a package bottom layer (1) carrying a chip (7) having at least one electronic component and having electric terminals (71) at a first side facing away from the bottom layer, the package bottom layer further carrying a patterned layer (2) having an elevated section (21) and a recessed section (22), the chip being accommodated in the recessed section and being circumferentially enclosed by the elevated section;

Providing a first connector membrane layer (81) extending over the first side of the chip and the elevated section (21) of the patterned layer (2) and defining openings (810) giving access to respective ones of the electric terminals;

Depositing conductor lines (82) of an electrically conductive material on the first connector membrane layer (81), the conductor lines electrically connecting respective ones of the electric terminals (71) with respective package terminals (82T);

Depositing on the first connector membrane layer (81) with the conductor lines (82) a second connector membrane layer (83), therewith enclosing the conductor lines between the first connector membrane layer and the second connector membrane layer,

wherein one or more of the first connector membrane layer (81) and the second connector membrane layer is provided with the method of either of the claims 1-13.

15. The method according to claim 14, wherein providing the package bottom layer (1) with the chip (7) comprises:

on a substrate (1) providing a first patterned sublayer of the patterned layer having an elevated section (21a) and a recessed section (22a);
providing a first flexible membrane (90) on the elevated section (21a) of the first patterned layer;
on the first flexible membrane (90) providing a second patterned sublayer having an elevated section (21b) and a recessed section (22b), wherein the elevated section (21b) of second patterned sublayer is supported by the elevated section (21a) of first patterned sublayer via the first flexible membrane (90);
adhering the chip (7) to a surface of the first flexible membrane (90) facing away from the substrate.

16. The method according to claim 14 or 15, comprising providing a further patterned layer having an elevated section (21c) that is supported by the elevated section (21b) of second patterned sublayer via the connector membrane layers (81,83);
depositing a cover layer (25) on the elevated section (21c) of the further patterned layer.

17. A manufacturing apparatus (200, 200A, 200B) comprising:

a deposition device (204);
a controllable light source (206);
a lamination/delamination facility (205);
a controller (250);
wherein the controller (250) is configured to subsequently:

control the deposition device (204) to deposit a layer (6) of an uncured resin on a film (5);

control the controllable light source (206) to direct photon radiation via the film (5) to the uncured resin layer (6) in first lateral regions (51), wherein a wavelength and an intensity of the radiation are selected in relation to a thickness and transmission characteristics of the resin layer to achieve that therein a first resin sublayer (61) at a side of the film having cured lateral sections (611) is formed in said first lateral regions (51) and that resin material in a second resin sublayer (62) having a free surface (622) at a side of the resin layer facing away from the radiation transparent film remains uncured;

control the lamination/delamination facility (205) to laminate the film (5) with a target (T), wherein the resin layer (6) faces the target;

control the controllable light source (206) to direct photon radiation via the film (5) in at least a third lateral region (53) to the resin layer (6) to fully cure the resin layer (6) in said at least a third lateral region (53);

control the lamination/delamination facility (205) to delaminate the film from the target, to therewith remove the film (5) and resin material thereon outside the at least a third lateral region (53) from the target, and leaving the fully cured material of the resin layer present in the at least a third lateral region on the target.

18. A manufacturing arrangement (1000A, 1000B) comprising a plurality of manufacturing zones (Z1, ...,Z6) arranged along a first direction (y) and comprising at least one track (222, 222a, 222b) to move at least one building platform (214a, 214b; 214c, 214d) for supporting a target between said manufacturing zones and wherein a manufacturing apparatus (200, 200A, 200B) according to claim 17 is arranged in one of said manufacturing zones and having arranged along a second direction (x) transverse to said first direction an unwind roller (201) to supply a film (5) a slot die coating head (204) forming the deposition device (204), a rewind roller (209) to rewind the film, and the lamination/delamination facility (205) is a roller, wherein both the controllable light source (206) and the roller (205) are movably arranged along the second direction.

19. The manufacturing arrangement according to claim 18, further comprising at least a first and a second thermal curing & solvent extraction station (219a, 219b; 129a1, 219a2, 219b1, 219b2) at a respective side in the first direction of the manufacturing apparatus.

20. The manufacturing arrangement (1000A) comprising at least a first and a second track (222a, 222b), each track enabling a pair of a first and a second building platform (214a, 214b) to be moved in the first direction independently from each other, and wherein the deposition device (204) is configured to deposit the uncured resin layer (6) over a length of the film (5) extending over said at least a first and a second track (222a, 222b) in a single cycle.

PRIOR ART

FIG. 1A

FIG. 1B

FIG. 1C

FIG. 1D

FIG. 2

FIG. 3

FIG. 4

FIG. 5



FIG. 6A

FIG. 6B

FIG. 7A

FIG. 7B

FIG. 7C

FIG.7D

S2AA

5 →
61 →

FIG. 8A

51          51          51          S2BB

5 →
61 →

FIG. 8B

8 →

51          51          51          S2CC

5 →
61 →
62 →

FIG. 8C

5

613

IXB ↓  614

615

FIG. 9A

| 61C |
| 61U |

5 →

61

62

613

614

615

613

614

FIG. 9B

FIG. 10A

FIG. 10B

FIG. 10C

FIG. 11A

FIG. 11B

FIG. 12A

FIG. 12B

FIG. 13A

FIG. 13B

FIG. 13C

FIG. 14A

FIG. 14B

FIG. 15A

FIG. 15B

2c

2m

200 µm

FIG. 15C

2c

2m

200 µm

FIG. 15D

FIG. 16

FIG. 17

FIG. 18

200A

202
203
205
52
206
51
z3
207
5
209
201
6
61a
61b
217
204
T
214
208
211
z2
212
212A
y2

z
y  x

FIG. 19

FIG. 20

FIG. 21

FIG. 22

FIG. 23

FIG. 24

FIG. 25

FIG. 26

FIG. 27

**FIG. 28**

FIG. 29

EP 4 108 628 A1

Europäisches
Patentamt

European
Patent Office

Office européen
des brevets

# EUROPEAN SEARCH REPORT

**Application Number**

EP 21 18 0945

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/268553 A1 (FREE MICHAEL BENTON [US] ET AL) 15 September 2016 (2016-09-15) | 1,17 | INV.<br>B81C1/00 |
| A | * figure 9 * | 2-16, 18-20 | |
| | ----- | | |

**TECHNICAL FIELDS SEARCHED (IPC)**

B81C
B81B

The present search report has been drawn up for all claims

| Place of search | Date of completion of the search | Examiner |
|---|---|---|
| Berlin | 22 December 2021 | McGinley, Colm |

EPO FORM 1503 03.82 (P04C01)

## ANNEX TO THE EUROPEAN SEARCH REPORT
## ON EUROPEAN PATENT APPLICATION NO.

EP 21 18 0945

This annex lists the patent family members relating to the patent documents cited in the above-mentioned European search report.
The members are as contained in the European Patent Office EDP file on
The European Patent Office is in no way liable for these particulars which are merely given for the purpose of information.

22-12-2021

| Patent document cited in search report | Publication date | Patent family member(s) | Publication date |
|---|---|---|---|
| US 2016268553 A1 | 15-09-2016 | CN 105706242 A | 22-06-2016 |
| | | EP 3069384 A1 | 21-09-2016 |
| | | JP 2016538689 A | 08-12-2016 |
| | | KR 20160085286 A | 15-07-2016 |
| | | TW 201523871 A | 16-06-2015 |
| | | US 2016268553 A1 | 15-09-2016 |
| | | WO 2015069444 A1 | 14-05-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1719607 A